# EUROPEAN PATENT APPLICATION

(11) **EP 4 822 375 A1**
(43) Date of publication of application: **14.10.2026**
(21) Application number: 24900983.8
(22) Date of filing: 29.11.2024
(51) Int. Cl.: G01R 31/52, G01R 31/66, G01R 31/00, G01R 15/04, G01R 1/30, G01R 19/165, B60L 53/60

(54) **APPARATUS AND METHOD FOR DETECTING PE OPEN OF ELECTRIC VEHICLE CHARGING CONTROLLER**

(30) Priority: 05.12.2023 KR 20230174680
(71) Applicant: LG Innotek Co., Ltd., Seoul 07796 (KR)
(72) Inventor: SHIN, Kwang Seob, Seoul 07796 (KR); KIM, Hyun Woong, Seoul 07796 (KR); SONG, Il Jong, Seoul 07796 (KR)
(74) Representative: Plasseraud IP
(86) International application number: PCT/KR2024/019333
(87) International publication number: WO 2025/121797

(57) **Abstract**

A protective earth (PE) open detection device for an electric vehicle charging controller (EVCC) according to an embodiment of the present invention includes a first voltage detection unit configured to detect a negative voltage on a connector proximity detection line, and a control unit configured to determine a PE open between an electric vehicle supply equipment (EVSE) and the EVCC based on the voltage value detected by the first voltage detection unit falling within a predetermined range.

## Description

### [Technical Field]

The present invention relates to an electric vehicle, and more particularly, to a device and method for detecting PE open in an electric vehicle charging controller.

### [Background Art]

Eco-friendly vehicles, such as Electric Vehicles (EVs) or Plug-In Hybrid Electric Vehicles (PHEVs), rely on electric vehicle supply equipment (EVSE) installed at charging stations to replenish their battery power.

To charge an electric vehicle, the EV and EVSE communicate through a charging connector that connects the EV to the EVSE. Once the charging connector is connected between the EVSE and the EV, a signaling process ensues to initiate the charging operation.

A high-voltage current flows between the EVSE and the EV, and in the event of an emergency shutdown, the EV can transmit a stopping message specifying the reason for shutdown to the EVSE.

When the PE line, serving as the grounding wire between the EVSE and EV, is open, an emergency shutdown is necessary for safety reasons. Consequently, a technology is required to rapidly and accurately detect PE open.

### [Disclosure]

### [Technical Problem]

It is an object of the present invention to provide a device and method for rapidly and accurately detecting the protective earth (PE) open in an electric vehicle charging controller.

A protective earth (PE) open detection device for an electric vehicle charging controller (EVCC) according to an embodiment of the present invention includes a first voltage detection unit configured to detect a negative voltage on a connector proximity detection line, and a control unit configured to determine a PE open between an electric vehicle supply equipment (EVSE) and the EVCC based on the voltage value detected by the first voltage detection unit falling within a predetermined range.

The control unit may estimate the negative voltage of the voltage value detected by the first voltage detection unit using a pre-stored voltage matching table.

The first voltage detection unit may include a back-to-back field-effect transistor (FET) connected to the connector proximity detection line, a positive voltage monitoring circuit, and a negative voltage monitoring circuit including a voltage divider resistor section and an operational amplifier (OP Amp).

The voltage divider resistor section may include a first resistor and a second resistor, one end of the first resistor being connected to the connector proximity detection line, and the other end of the first resistor being connected to one end of the second resistor and to the OP Amp.

The first resistor may be 100kΩ or more.

The positive voltage monitoring circuit may include a voltage divider resistor section and an OP Amp.

The PE open detection device may further include a second voltage detection unit configured to detect a voltage on a charging state detection line.

The second voltage detection unit may include a voltage divider resistor section and an operational amplifier (OP Amp).

The voltage divider resistor section may include a first resistor and a second resistor, one end of the first resistor being connected to the charging state detection line, and the other end of the first resistor being connected to one end of the second resistor and to the OP Amp.

The first resistor may be 100kΩ or more.

A protective earth (PE) open detection method for an electric vehicle charging controller (EVCC) according to an embodiment of the present invention includes detecting a negative voltage on a connector proximity detection line, and determining a PE open between an electric vehicle supply equipment (EVSE) and the EVCC based on the voltage value detected by the first voltage detection unit falling within a predetermined range.

### [Advantageous Effects]

The electric vehicle charging controller according to an embodiment of the present invention is advantageous in terms of being capable of rapidly and accurately detecting the PE open between the EVSE and the EV.

### [Description of Drawings]

FIGS. 1 to 3 are diagrams illustrating a charging system for an electric vehicle according to an embodiment of the present invention.
FIG. 4 is a diagram illustrating the pinout of the connector included in the EVCC according to an embodiment of the present invention;
FIG. 5 is an equivalent circuit diagram of the charging interface between the EVSE and the EV;
FIG. 6 is an equivalent circuit diagram of the charging interface between an EVSE and an EVCC according to an embodiment of the present invention;
FIG. 7 is an equivalent circuit diagram between a second voltage detection unit and an EVSE according to an embodiment of the present invention; and
FIG. 8 is an equivalent circuit diagram between a first voltage detection unit and an EVSE according to an embodiment of the present invention.

### [Modes of the Invention]

Hereinafter, preferred embodiments of the present invention are described in detail with reference to the accompanying drawings.

However, the technical concept of the present invention is not limited to the embodiments described herein but can be implemented in various other forms, allowing for selective combination or substitution of one or more components among different embodiments within the scope of the technical concept of the present invention.

Unless explicitly defined otherwise, terms used in the embodiments of the present invention (including technical and scientific terms) should be interpreted in meanings understood by those skilled in the art to which the present invention pertains considering the context of the technology involved, rather than solely based on their usual or dictionary meanings.

Furthermore, the terminology employed in the embodiments of the present invention is intended solely for the purpose of elucidating the embodiments and should not be construed as limiting the scope of the present invention.

In this specification, singular language may include the plural unless specifically mentioned otherwise, and when stated as "at least one (or one or more) of A, B, and (or) C," it may include one or more of all possible combinations of A, B, and C.

Additionally, when describing the components of the embodiments of the present invention, terms such as "first," "second," "A," "B," "(a)," and "(b)" may be used.

These terms are intended solely for the purpose of distinguishing one component from another and do not limit the essence, order, or sequence of respective components.

Furthermore, when a component is described as being "connected," "coupled," or "attached" to another component, it may include not only direct connection, coupling, or attachment but also connection, coupling, or attachment through another component located between the component and the other component.

Additionally, when a component is described as being formed or placed "on or under" another component, "on (above)" or "under (below)" may include not only cases where two components directly contact each other but also cases where one or more other components are formed or positioned between the two components. Additionally, when expressed as "on (above or under (below)," it may include not only the upward direction but also the downward direction relative to a single component.

Hereinafter, a description is made of the charging system for a vehicle with reference to the accompanying drawings where identical or corresponding components are assigned the same reference numbers, and redundant descriptions are omitted.

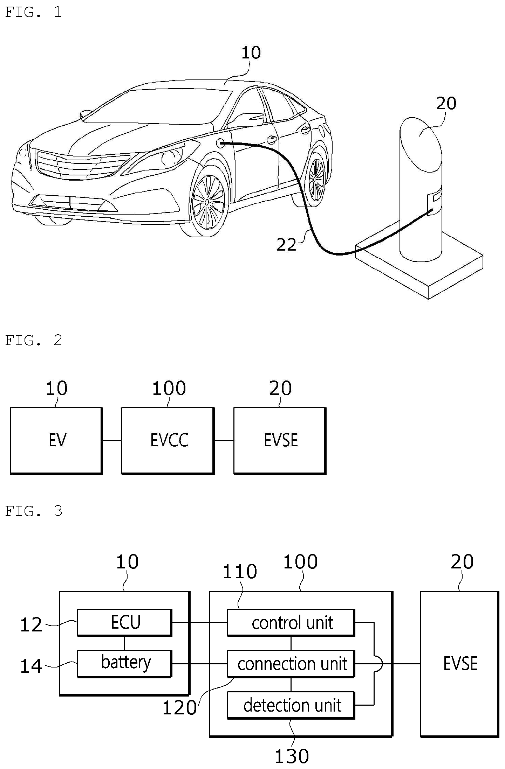

FIGS. 1 to 3 are diagrams illustrating a charging system for an electric vehicle according to an embodiment of the present invention.

With reference to FIGS. 1 to 3, an electric vehicle (EV) 10 may be charged from electric vehicle supply equipment (EVSE) 20. To achieve this, the charging cable 22 connected to the EVSE 20 may be connected to the charging port of the EV 10. Here, EVSE 20 is a facility that supplies AC or DC power, which may be installed at charging stations, within homes, or designed to be portable. EVSE 20 may be interchangeably referred to as a charging station, AC charger, DC charger, or socket-outlet.

The electric vehicle charging controller (EVCC) 100 is installed within the EV 10 and is connected to the EV 10. For example, the EVCC 100 may be installed inside the trunk of the EV 10, but this is not limiting.

Here, the EVCC 100 may communicate with both the EV 10 and the EVSE 20.

According to an embodiment of the present invention, the EVCC 100 includes a control unit 110, a connection unit 120, and a detection unit 130.

The control unit 110 generates control signals for charging between the EV 10 and EVSE 20. The control signals for charging generated by the control unit 110 may be transmitted to the EVSE 20 via the connection unit 120 or to the electric control unit (ECU) 12 within the EV 10.

The connection unit 120 is connected to the EVSE 20 and transmits signals between the control unit 110 and the EVSE 20. For example, the connection unit 120 may relay charging-related signals received from the EVSE 20 to the control unit 110 and may transmit control signals for charging generated by the control unit 110 to the EVSE 20. The connection unit 120 may also deliver power received from the EVSE 20 to the battery 14 inside the EV 10 according to the charging control signals generated by the control unit 110.

The detection unit 130 detects charging-related signals between the EV 10 and EVSE 20. The detection unit 130 is connected to both the connection unit 120 and the control unit 110 to relay the detected values from the connection unit 120 to the control unit 110.

Here, some components of the EVCC 100 may be used to detect the PE open. Accordingly, in this specification, the EVCC 100 may be referred to interchangeably as the PE open detection device or the PE open detection device of the electric vehicle charging controller.

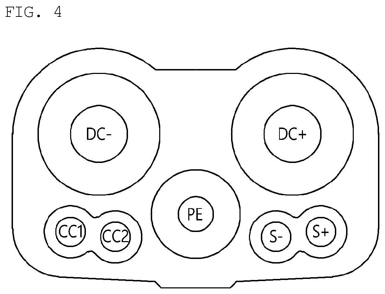

FIG. 4 is a diagram illustrating the pinout of the connector included in the EVCC according to an embodiment of the present invention. The pinout illustrated in FIG. 4 may represent the configuration seen at the end of the EV-side connector.

With reference to FIG. 4, the connection unit 120 may include a total of 7 pins. For example, the connection unit 120 may include a DC+ pin, a DC- pin, a PE pin, a CC1 pin, a CC2 pin, an S+ pin, and an S- pin.

Here, the PE pin acts as a ground pin and may serve as a reference for the control line. The PE pin may be included in the grounding wire between the EVSE 20 and the EVCC 100. The CC1 (connection confirmation 1) pin and CC2 (connection confirmation 2) pin are used for connection confirmation between the EVSE 20 and the EV 10, where the CC1 pin may be used to distinguish the charging states or charging modes, and the CC2 pin may be used for connector proximity detection.

The DC+ pin and DC- pin may be fast charging terminals for receiving power from the EVSE 20.

The S+ pin and S- pin are used for signaling between the EVSE 20 and the EV 10 and may be a CAN bus.

This EV 10 side connector may be a Chaoji connector, known as CHAdeMO 3.0, and may be compatible with CHAdeMO or GB/T DC charging systems.

Meanwhile, the end of the connector on the EVSE 20 side may have a shape corresponding to the end of the connector on the EV 10 side.

As described above, the EVCC 100 may be installed within the EV 10. Therefore, in this specification, the EV 10 side may refer to the EVCC 100. That is, the EVCC 100 may be referred to interchangeably as the EV 10 side in this specification.

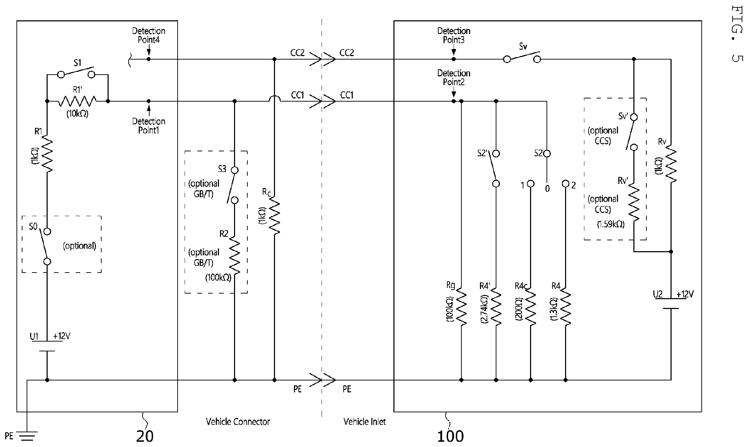

FIG. 5 is an equivalent circuit diagram of the charging interface between the EVSE and the EV.

With reference to FIG. 5, a control pilot (CP) circuit between the EVSE 20 and the EV 10 sides includes power sources U1 and U2, switches S1, S2, S2'and Sv, and resistors R1, R1', Rg, R4, R4', Rc, and Rv. Switch S0 is an optional component that remains open at all times to reduce the risk of a short between the power source U1 and PE at the connector pin when the connector is not in use. Switch S3 and resistor R2 are optional components used on the EVSE 20 side to detect the integrity of the PE and CC1 lines before connecting the connector. The EVSE 20 and EV 10 sides may continuously monitor and evaluate voltage values at detection points (DPs) 1 and 2, regardless of the charging preparation state or abnormal condition. Detection point (DP) 3 may be monitored to detect faults in the EV 10 side CC2 circuit caused by the on-stuck state of switch Sv. Switch Sv remains open during charging to prevent the issue of dual supply to the CP circuit due to PE open. In case of an emergency during charging, at least one of switches S1 and S2 may open. Resistors R4', R4c, and R4 and switches S2' and S2) may be configured to enable compatibility between different charging standards. For example, when the equivalent circuit shown in FIG. 5 is according to the Chaoji standard, the connection state of switches S2' and S2 may allow compatibility with non-Chaoji standards, such as the GB/T standard or CHAdeMO standard.

Referring to the equivalent circuit in FIG. 5 to explain the connection between the EVSE 20 and the EV 10 sides, the EV 10 side wakes up when the voltage at DP 2 reaches 12V, and switch Sv is turned on. When the CC2 circuit is in a closed state, the voltage at DP 3 is detected as 6V. At this time, the EV 10 side may recognize that the connector is connected. The EVSE 20 may recognize the connector as connected when the voltage at DP 1 drops. The EVSE 20 then closes switch S1 to prepare for charging. Afterward, CAN communication between the EVSE 20 and the EV 10 sides begins.

Meanwhile, according to an embodiment of the present invention, the detection unit 130 detects a PE open between the EV 10 and the EVSE 20. Here, PE refers to the grounding wire between the EVCC 100 and the EVSE 20, and a PE open indicates a disconnected grounding wire between the EVCC 100 and the EVSE 20. In this specification, a PE open may also be referred to as a broken PE.

In the charging interface between the EVSE 20 and the EVCC 100 illustrated in FIG. 5, when the grounding wire is disconnected, i.e., when a PE open occurs, the positive voltage values at DP 2 on the CC1 line and DP 3 on the CC2 line may deviate from their normal values. However, even in fault conditions other than a PE open, the positive voltage values at DP 2 on the CC1 line and DP 3 on the CC2 line may also deviate from their normal values. Accordingly, relying solely on the positive voltage values at DP 2 on the CC1 line and DP 3 on the CC2 line may make it difficult to quickly detect a PE open. Therefore, a faster and more accurate PE open detection method is needed.

In an embodiment of the present invention, a cost-effective, fast, and accurate PE open detection structure can be implemented by modifying the circuit of the charging interface between the EVSE and the EV.

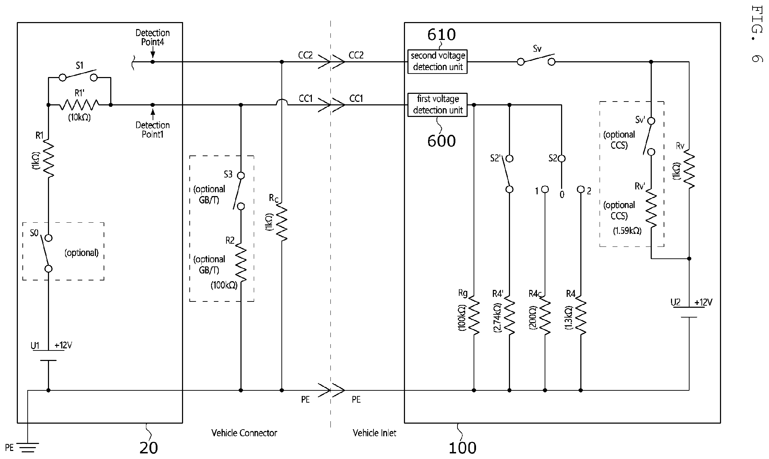

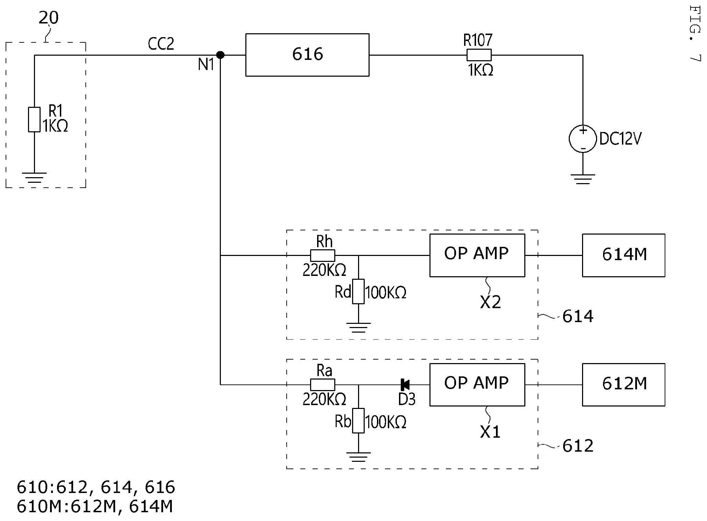

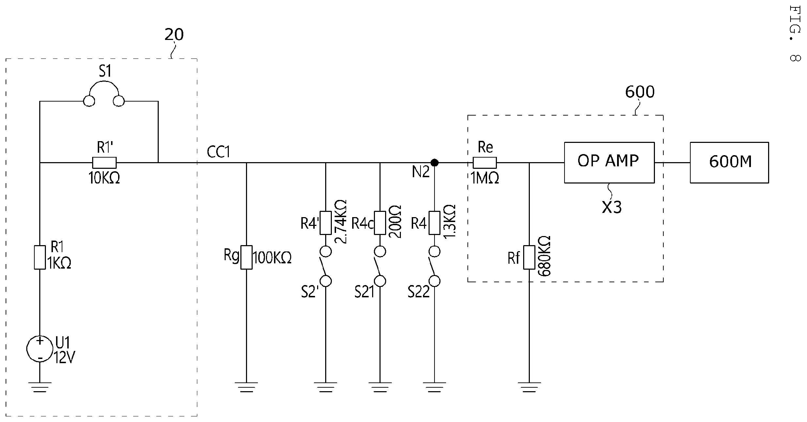

FIG. 6 is an equivalent circuit diagram of the charging interface between an EVSE and an EVCC according to an embodiment of the present invention, FIG. 7 is an equivalent circuit diagram between a second voltage detection unit and an EVSE according to an embodiment of the present invention, and FIG. 8 is an equivalent circuit diagram between a first voltage detection unit and an EVSE according to an embodiment of the present invention.

With reference to FIGS. 6 to 8, the EVSE 20 and the EVCC 100 are connected by the CC1 (connection confirmation 1) line, the CC2 (connection confirmation 2) line, and the PE (protective earth) line. The CC1 line is used to distinguish the charging state or charging mode, and the CC2 line may be used for connector proximity detection. Accordingly, the CC1 line may be referred to as the charging state detection line, and the CC2 line may be referred to as the connector proximity detection (PP) line. The PE line may be referred to as the grounding line. The EVCC 100 may recognize the charging state or charging mode based on the voltage value of the CC1 line and detect the proximity of the connector based on the voltage value of the CC2 line.

According to an embodiment of the present invention, the detection unit 130 of the EVCC 100 includes a first voltage detection unit 600 connected to the CC1 line to detect the voltage value of the CC1 line, and a second voltage detection unit 610 connected to the CC2 line to detect the voltage value of the CC2 line. Here, the second voltage detection unit 610 may include a negative voltage monitoring circuit 612 for monitoring the negative voltage on the CC2 line and a positive voltage monitoring circuit 614 for monitoring the positive voltage on the CC2 line.

The control unit 110 of the EVCC 100 includes a CC1 MCU 600M that generates charging control signals based on the detection values from the CC1 detection unit 600, and a CC2 MCU 610M that generates charging control signals based on the detection values from the CC2 detection unit 610. The CC2 MCU 610M may include a PE open MCU 612M that generates a charging control signal for a PE open based on the detection values from the negative voltage monitoring circuit 612 of the second voltage detection unit 610, and a proximity signal MCU 614M that generates a charging control signal for connector proximity based on the detection values from the positive voltage monitoring circuit 614 of the second voltage detection unit 610. Although the CC1 MCU 600M, PE open MCU 612M, and proximity signal MCU 614M are shown as independent MCUs, the implementation is not limited to this configuration, and the CC1 MCU 600M, PE open MCU 612M, and proximity signal MCU 614M may be implemented as a single integrated MCU.

The PE open MCU 612M is connected to the negative voltage monitoring circuit 612, and when the voltage value detected by the negative voltage monitoring circuit 612 is within a predetermined range, the PE open MCU 612M determines that the PE between the EVSE 20 and the EVCC 100 is open.

In more detail, when the PE is open, current flows from the power source U1 of the EVSE 20 through the CC1 line, the switch S2' of the EVCC 100, switch S2, the CC2 line, and the resistor Rc of the EVSE 20 back to the power source U1 of the EVSE 20 due to the resistance components of the second voltage detection unit 610, resulting in a negative voltage on the CC2 line. Accordingly, in this embodiment of the present invention, the negative voltage across the CC2 line is used to detect a PE open.

According to an embodiment of the present invention, the second voltage detection unit 610 includes a negative voltage monitoring circuit 612, a positive voltage monitoring circuit 614, and a dual FET 616 connected to the CC2 line. Here, the dual FET 616 may include two FETs connected in a back-to-back configuration. Accordingly, in this specification, the dual FET 616 may also be referred to as a back-to-back FET. The back-to-back FET is positioned between the first node (N1) of the CC2 line and DC 12V. The back-to-back FET consists of two FETs connected in series, with their body diodes oriented in opposite directions, thus preventing bidirectional current flow. When the back-to-back FET is positioned between the first node (N1) of the CC2 line and DC 12V, current flow through the CC2 line toward the EVCC 100 from the EVSE 20 is allowed, but current flow from the EVCC 100 toward the EVSE 20 through the CC2 line is blocked. This configuration prevents the formation of a short circuit between the CC1 line and the CC2 line even in the case of a PE open.

According to an embodiment of the present invention, the negative voltage monitoring circuit 612 is connected to the first node N1 of the CC2 line. The negative voltage monitoring circuit 612 may include a voltage divider resistor section and an operational amplifier (OP Amp) X1. Here, the voltage divider resistor section is positioned between the first node N1 of the CC2 line and the OP Amp X1 to divide the voltage applied to the OP Amp X1. For example, the voltage divider resistor section may include a first resistor Ra and a second resistor Rb, where one end of the first resistor Ra may be connected to the first node N1 of the CC2 line, and the other end of the first resistor Ra may be connected to one end of the second resistor Rb and the OP Amp X1. In this case, the first resistor Ra may have a value of 100kΩ or more, preferably 100kΩ or more and 1000kΩ or less, and more preferably 100kΩ or more and 500kΩ or less. As such, when the first resistor Ra of the voltage divider resistor section is designed to be 100kΩ or more, a structure can be achieved that accurately detects the voltage value without electrically affecting the surrounding circuits.

According to an embodiment of the present invention, the negative voltage monitoring circuit 612 may further include a diode D3 positioned between the voltage divider resistor section and the OP Amp X1. The cathode of the diode D3 may be connected to the voltage divider resistor section, while the anode may be connected to the OP Amp X1. This configuration can prevent current flow from the OP Amp X1 to the voltage divider resistor section, allowing the monitoring of negative voltages on the CC2 line.

Meanwhile, the PE open MCU 612M is connected to the negative voltage monitoring circuit 612, and when the voltage value detected by the negative voltage monitoring circuit 612 falls within a predetermined range, the PE open MCU 612M determines a PE open between the EVSE 20 and EVCC 100. To facilitate this determination, the PE open MCU 612M may store a voltage matching table in advance to estimate the negative voltage using the voltage value detected by the negative voltage monitoring circuit 612. Table 1 is an example of the voltage matching table stored in advance by the PE open MCU 612M. For example, the PE open MCU 612M may estimate the voltage value of the CC2 line as -1V for a reading of 0.05V, -5V for a reading of 0.92V, and -8V for a reading of 1.64V. Furthermore, when the voltage read by the PE open MCU 612M is between 0.68V and 3.08V, the PE open MCU 612M may determine that a meaningful negative voltage is applied to the CC2 line and determines that the PE is in an open state.

**[Table 1]**

| CC2 line voltage value (V) | Detected voltage value (V) | PE open detection range |
|---|---|---|
| 0 | 0 | |
| -1 | 0.05 | |
| -2 | 0.24 | |
| -3 | 0.46 | |
| -4 | 0.68 | PE open detection |
| -5 | 0.92 | |
| -6 | 1.16 | |
| -7 | 1.4 | |
| -8 | 1.64 | |
| -9 | 1.88 | |
| -10 | 2.12 | |
| -11 | 2.35 | |
| -12 | 2.6 | |
| -13 | 2.85 | |
| -14 | 3.08 | |
| -15 | 3.32 | |
| -16 | 3.51 | |

As in the embodiment of the present invention, using the negative voltage applied to the CC2 line to detect a PE open enables fast and accurate detection of a PE open.

Meanwhile, according to an embodiment of the present invention, the positive voltage monitoring circuit 614 may also include a voltage divider resistor section and an OP Amp X2. Here, the voltage divider resistor section is positioned between the first node N1 of the CC2 line and the OP Amp X2 to divide the voltage applied to the OP Amp X2. For example, the voltage divider resistor section may include a first resistor Rh and a second resistor Rd, where one end of the first resistor Rh may be connected to the first node N1 of the CC2 line, and the other end of the first resistor Rh may be connected to one end of the second resistor Rd and the OP Amp X2. In this case, the first resistor Rh may have a value of 100kΩ or more, preferably 100kΩ or more and 1000kΩ or less, and more preferably 100kΩ or more and 500kΩ or less. According to an embodiment of the present invention, when the positive voltage monitoring circuit 614 includes a voltage divider resistor section, the control unit 110 can detect high voltage values of 12V or more and 16V or less applied to the input line. Additionally, when the voltage divider resistor section of the positive voltage monitoring circuit 614 includes a high first resistor Rh of 100kΩ or more, the electrical impact on the CC2 line by the positive voltage monitoring circuit 614 can be minimized, thereby improving the accuracy of negative voltage detection on the CC2 line.

As described with reference to FIGS. 6 to 8, the first node N1 of the CC2 line may be connected to the negative voltage monitoring circuit 612, the positive voltage monitoring circuit 614, and the dual FET 616. Accordingly, in a normal state, a proximity detection signal may be transmitted from the EVSE 20 to the EVCC 100 through the dual FET 616, the positive voltage monitoring circuit 614 may detect the proximity detection signal. When the PE is open, the dual FET 616 prevents the formation of a closed circuit between the CC1 and CC2 lines, and the negative voltage monitoring circuit 612 can detect the negative voltage on the CC2 line.

According to an embodiment of the present invention, the CC1 detection unit 600 detects the voltage value of the CC1 line. The CC1 MCU 600M may estimate the voltage value of the CC1 line based on the results from the CC1 detection unit 600, determining whether the EVCC 100 is in a wake-up or sleep mode, or whether the EVSE 20 and EVCC 100 are in a charging state.

For this purpose, the CC1 detection unit 600 may include a voltage divider resistor section and an OP Amp X3. The voltage divider resistor section is positioned between the second node N2 of the CC1 line and the OP Amp X3, allowing it to divide the voltage entering the OP Amp X3. For example, the voltage divider resistor section may include a first resistor Re and a second resistor Rf, where one end of the first resistor Re may be connected to the second node N2 of the CC1 line, and the other end of the first resistor Re may be connected to one end of the second resistor Rf and the OP Amp X3. In this configuration, the first resistor Re may have a resistance of 100kΩ or more, preferably between 100kΩ and 1000kΩ, and more preferably between 100kΩ and 500kΩ.

When the CC1 detection unit 600 includes a voltage divider resistor section and the EVSE 20 outputs a 12V waveform, the CC1 detection unit 600 may obtain a result value lower than 12V, for example, about 3V, which the control unit 110 may use to estimate the voltage value of the CC1 line. In particular, when the first resistor of the voltage divider resistor section of the CC1 detection unit 600 is designed to be 100kΩ or more, even when a voltage of 16V is applied to the input line, the CC1 detection unit 600 may obtain a result value less than 16V, for example, about 4V. In this way, when the CC1 detection unit 600 includes a voltage divider resistor section according to an embodiment of the present invention, the control unit 110 may detect high voltage values on the CC1 line, for example, values of 12V or more and 16V or less. Furthermore, by including a high first resistor of 100kΩ or more in the voltage divider resistor section of the CC1 detection unit 600, the electrical influence of the CC1 detection unit 600 on the CC2 line can be minimized, thereby improving the accuracy of negative voltage detection on the CC2 line.

Although the preferred embodiments of this invention have been described above, it will be understood by those skilled in the art that this invention can be variously modified and changed without departing from the spirit and scope of this invention as set forth in the following patent claims.

### [DESCRIPTION OF REFERENCE NUMERALS]

10: EV
20: EVSE
22: charging cable
100: EVCC
110: control unit
120: connection unit
130: detection unit

## Claims

1. A protective earth (PE) open detection device for an electric vehicle charging controller (EVCC), the device comprising:
a first voltage detection unit configured to detect a negative voltage on a connector proximity detection line; and
a control unit configured to determine a PE open between an electric vehicle supply equipment (EVSE) and the EVCC based on the voltage value detected by the first voltage detection unit falling within a predetermined range.

2. The PE open detection device of claim 1, wherein the control unit estimates the negative voltage of the voltage value detected by the first voltage detection unit using a pre-stored voltage matching table.

3. The PE open detection device of claim 1, wherein the first voltage detection unit comprises:
a back-to-back field-effect transistor (FET) connected to the connector proximity detection line;
a positive voltage monitoring circuit; and
a negative voltage monitoring circuit comprising a voltage divider resistor section and an operational amplifier (OP Amp).

4. The PE open detection device of claim 3, wherein the voltage divider resistor section comprises a first resistor and a second resistor, one end of the first resistor being connected to the connector proximity detection line, and the other end of the first resistor being connected to one end of the second resistor and to the OP Amp.

5. The PE open detection device of claim 4, wherein the first resistor is 100kΩ or more.

6. The PE open detection device of claim 3, wherein the positive voltage monitoring circuit comprises a voltage divider resistor section and an OP Amp.

7. The PE open detection device of claim 1, further comprising a second voltage detection unit configured to detect a voltage on a charging state detection line.

8. The PE open detection device of claim 7, wherein the second voltage detection unit comprises a voltage divider resistor section and an operational amplifier (OP Amp).

9. The PE open detection device of claim 8, wherein the voltage divider resistor section comprises a first resistor and a second resistor, one end of the first resistor being connected to the charging state detection line, and the other end of the first resistor being connected to one end of the second resistor and to the OP Amp.

10. The PE open detection device of claim 9, wherein the first resistor is 100kΩ or more.
